# EUROPÄISCHE PATENTSCHRIFT

(11) **EP 1 095 410 B1**
(45) Veröffentlichungstag und Bekanntmachung des Hinweises auf die Patenterteilung: **09.08.2006**
(21) Anmeldenummer: 99938134.6
(22) Anmeldetag: 07.06.1999
(51) Int. Cl.: H01L 29/45

(54) **HALBLEITERANORDNUNG MIT OHMSCHER KONTAKTIERUNG UND VERFAHREN ZUR KONTAKTIERUNG EINER HALBLEITERANORDNUNG**
SEMICONDUCTOR ARRANGEMENT WITH OHMIC CONTACT AND A METHOD FOR CONTACTING A SEMICONDUCTOR ARRANGEMENT
DISPOSITIF A SEMI-CONDUCTEUR AVEC METALLISATION OHMIQUE, ET PROCEDE DE METALLISATION D'UN DISPOSITIF A SEMI-CONDUCTEUR

(30) Priorität: 08.06.1998 DE 19825520
(43) Veröffentlichungstag der Anmeldung: 02.05.2001
(73) Patentinhaber: SiCED Electronics Development GmbH & Co KG, 91052 Erlangen (DE)
(72) Erfinder: FRIEDRICHS, Peter, D-90419 Nürnberg (DE); PETERS, Dethard, D-91315 Höchstadt (DE); SCHÖRNER, Reinhold, D-91091 Grossenseebach (DE)
(74) Vertreter: Berg, Peter
(86) Internationale Anmeldenummer: PCT/DE1999/001657
(87) Internationale Veröffentlichungsnummer: WO 1999/065081

(56) Entgegenhaltungen:
- S. LIU ET AL.: "Ohmic contacts to p-type SiC with improved thermal stability" MATERIALS SCIENCE FORUMS, Bd. 264-268, 1998, Seiten 791-794, XP002122833 Switzerland in der Anmeldung erwähnt
- PATENT ABSTRACTS OF JAPAN vol. 18, no. 299 (E-1558), 8. Juni 1994 (1994-06-08) & JP 06 061475 A (TOSHIBA CORP), 4. März 1994 (1994-03-04)
- G.L. HARRIS ET AL.: "Properties of silicon carbide" 1995 , G.L. HARRIS INSPEC XP002122834 in der Anmeldung erwähnt Seite 231 -Seite 234
- RASTEGAEVA M G ET AL: "The influence of temperature treatment on the formation of Ni-based Schottky diodes and ohmic contacts to n-6H-SiC" MATERIALS SCIENCE AND ENGINEERING B,CH,ELSEVIER SEQUOIA, LAUSANNE, Bd. 46, Nr. 1-3, Seite 254-258 XP004085322 ISSN: 0921-5107
- MARINOVA TS ET AL: "Nickel based ohmic contacts on SiC" MATERIALS SCIENCE AND ENGINEERING B,CH,ELSEVIER SEQUOIA, LAUSANNE, Bd. 46, Nr. 1-3, Seite 223-226 XP004085316 ISSN: 0921-5107
- HALLIN C ET AL: "Interface chemistry and electrical properties of annealed Ni and Ni/Al-6H SiC structures" SILICON CARBIDE AND RELATED MATERIALS 1995. PROCEEDINGS OF THE SIXTH INTERNATIONAL CONFERENCE, PROCEEDINGS OF INTERNATIONAL CONFERENCE ON SILICON CARBIDE AND RELATED MATERIALS, KYOTO, JAPAN, 18-21 SEPT. 1995, Seiten 601-604, XP000852891 1996, Bristol, UK, IOP Publishing, UK ISBN: 0-7503-0335-2
- HALLIN C ET AL: "Improved Ni ohmic contact on n-type 4H-SiC" PROCEEDINGS OF THE 38TH ELECTRONIC MATERIALS CONFERENCE, SANTA BARBARA, CA, USA, 26-28 JUNE 1996, Bd. 26, Nr. 3, Seiten 119-122, XP000852876 Journal of Electronic Materials, March 1997, TMS, USA ISSN: 0361-5235

## Beschreibung

Die Erfindung bezieht sich auf eine Halbleiteranordnung mit ohmscher Kontaktierung gemäß dem Oberbegriff des Patentanspruches 1 sowie auf ein Verfahren zur Kontaktierung einer Halbleiteranordnung gemäß dem Oberbegriff des Patentanspruches 4. Insbesondere betrifft die Erfindung eine derartige Halbleiteranordnung, die zumindest in bestimmten Halbleitergebieten, insbesondere den Halbleitergebieten, die kontaktiert werden, aus einem vorbestimmten Polytyp des Siliciumcarbids besteht. Dabei sind die zu kontaktierenden Halbleitergebiete p-leitend.

Siliciumcarbid (SiC) in einkristalliner Form ist ein Halbleitermaterial mit hervorragenden physikalischen Eigenschaften, die dieses Halbleitermaterial unter anderem aufgrund seiner hohen Durchbruchfeldstärke und seiner guten thermischen Leitfähigkeit besonders für die Leistungselektronik auch noch bei Anwendungen im kV-Bereich interessant erscheinen lassen. Da die kommerzielle Verfügbarkeit einkristalliner Substratwafer speziell aus Siliciumcarbid des 6H- und 4H-Polytyps gestiegen ist, finden nun auch Leistungshalbleiter Bauelemente auf Siliciumcarbidbasis wie z.B. Schottky-Dioden zunehmend an Beachtung. Andere Siliciumcarbid-Bauelemente mit steigendem Verbreitungsgrad sind pn-Dioden und Transistoren wie beispielsweise MOSFET's (Metal Oxide Semiconductor Field Effect Transistors).

Für die Funktion dieser Bauelemente sind stabile ohmsche Kontakte zu Halbleitergebieten unterschiedlichen Leitungstyps unabdingbar. Dabei werden möglichst niedrige Kontaktwiderstände angestrebt, um unerwünschte Verluste am Übergang Halbleiter-Metall zu minimieren.

In dem Übersichtsaufsatz "*Ohmic contacts to SiC*" *von G.L. Harris et al. aus* "*Properties of Silicon Carbide*" *ed. by G.L. Harris INSPEC, 1995, Seiten 231-234* findet sich eine Zusammenstellung von Kontaktierungsverfahren für Siliciumcarbid verschiedenen Polytyps und Leitungstyps. Bezüglich der Kontaktierung von p-leitendem SiC ist dem Übersichtsaufsatz sowie den zitierten Querreferenzen der in der Fachwelt derzeit allgemein anerkannte Kenntnisstand zu entnehmen, der im folgenden skizziert wird:
Zur Kontaktierung von p-leitendem SiC wird überwiegend Aluminium verwendet. Da Aluminium in geringen Mengen in SiC löslich ist und als Akzeptor wirkt, kann in einem Grenzbereich zwischen dem Aluminium enthaltenden Kontaktgebiet und dem Halbleitergebiet aus SiC eine mit Aluminium hochdotierte Zone erzeugt werden. Um ein Abdampfen des Aluminiums, das bereits bei 659°C schmilzt, bei einer nachfolgenden Temperaturbehandlung zur Formierung des ohmschen Kontakts zu vermeiden, wird auf das Aluminium mindestens eine Deckschicht aus einem Material mit einem höheren Schmelzpunkt wie z.B. Nickel, Wolfram, Titan oder Tantal aufgebracht.

Um die vorteilhaften Kontakteigenschaften eines bestimmten Kontaktmaterials auf p-leitendem SiC ausnützen zu können, ist folglich nach diesen Verfahren des Standes der Technik eine zweite Schicht notwendig, die die darunterliegende erste Schicht schützt. Die erste und die zweite Schicht werden über getrennte, nacheinander ablaufende technologische Prozeßschritte mit jeweils verschiedenen Materialien aufgebracht. Ein Beispiel hierfür ist in der JP 06-061475 A1 angegeben, bei dem auf einem Nickelfilm eine Aluminiumelektrode als separater Film aufgebracht wird.

In dem Aufsatz "*Titanium and Aluminium-Titanium Ohmic Contacts to p-Type SiC*"*, Solid-State Electronics, Vol.41, No.11, 1997, Seiten 1725-1729* wird eine Aluminium-Titan-Legierung als Material für einen ohmschen Kontakt auf p-leitendem SiC offenbart. Die dabei verwendete Legierung weist für Aluminium einen Gewichtsanteil von 90 % und für Titan entsprechend einen Gewichtsanteil von 10 % auf. Der Kontakt aus der Aluminium-Titan-Legierung wird mit keiner weiteren Schicht bedeckt. In dem Aufsatz wird über Probleme bei der Reproduzierbarkeit und bei sehr dünnen Kontaktschichten berichtet. Insbesondere bei dünnen Kontaktschichten kann es zur Verflüchtigung des Aluminiums aus der Aluminium-Titan-Legierung kommen.

In dem Aufsatz "*Ohmic Contacts to p-type SiC with improved thermal stability*"*, LIU, S.,* et *al., 7*^{*th*} *International Conference on Silicon Carbide, III-Nitrides and Related Materials Stockholm, September 1997* wird ein ohmscher Kontakt auf p-leitendem SiC beschrieben, der über einen Schichtaufbau aus einer Aluminium-, einer Nickel- und einer Wolfram-Schicht hergestellt wird. Nach Aufbringen dieses Schichtaufbaus wird ein Temperprozeß durchgeführt, bei dem sich u.a. das Aluminium und das Nickel miteinander vermischen, wobei jedoch keine über die Tiefe des Kontaktgebiets homogene Materialzusammensetzung ausgebildet wird. Diese Vermischung findet außerdem auch nur bei Anwesenheit der dritten Schicht aus Wolfram statt. Aus dieser dritten Schicht wiederum diffundiert während des Temperprozesses ein erheblicher Anteil an Wolfram bis in den Grenzbereich des ohmschen Kontakts und des p-leitenden SiCs. Hierbei kann das Wolfram dann allerdings zu einer Verschlechterung des ohmschen Kontaktverhaltens führen.

Ausgehend vom vorstehend abgehandelten Stand der Technik ist es Aufgabe der Erfindung, eine Halbleiteranordnung sowie ein Verfahren der eingangs bezeichneten Art mit einer im Vergleich zum Stand der Technik verbesserten Kontaktierung von p-leitendem SiC anzugeben. Dabei soll der Kontakt auf dem p-leitenden Halbleitergebiet sowohl einen niedrigen Kontaktwiderstand haben als auch temperaturstabil sein.

Zur Lösung der die Halbleiteranordnung betreffenden Teilaufgabe wird eine Halbleiteranordnung entsprechend der Gesamtheit der Merkmale des unabhängigen Patentanspruches 1 angegeben.

Bei der erfindungsgemäßen Halbleiteranordnung mit ohmscher Kontaktierung handelt es sich um eine Halbleiteranordnung, welche in bekannter Weise
a) mindestens ein p-leitendes Halbleitergebiet aus Siliciumcarbid und
b) mindestens ein an das p-leitende Halbleitergebiet angrenzendes p-Kontaktgebiet umfaßt, wobei
c) das p-Kontaktgebiet aus einem Material mit Nickel als erster Materialkomponente und Aluminium als zweiter Materialkomponente besteht,
wobei aber nunmehr
d) im p-Kontaktgebiet eine annähernd gleiche Materialzusammensetzung der Materialkomponenten Nickel und Aluminium vorliegt, und
e) in einem Grenzbereich zwischen dem p-leitenden Halbleitergebiet und dem p-Kontaktgebiet ein quaternäres Materialsystem mit Silicium und Kohlenstoff sowie Nickel und Aluminium vorhanden ist.

Zur Lösung der das Verfahren betreffenden Teilaufgabe wird ein Verfahren entsprechend den Maßnahmen des unabhängigen Patentanspruchs 4 angegeben.

Bei dem erfindungsgemäßen Verfahren zur Kontaktierung einer Halbleiteranordnung handelt es sich um ein Verfahren, bei welchem
a) mindestens ein weitgehend homogenes p-Kontaktgebiet auf mindestens einem p-leitenden Halbleitergebiet aus Siliciumcarbid ausgebildet wird, indem
b) für das p-Kontaktgebiet ein Material mit Nickel und Aluminium als einer ersten bzw. einer zweiten Materialkomponente aufgebracht wird,
   c) wobei aber nunmehr beide Materialkomponenten gleichzeitig in einem vorgegebenen Mischungsverhältnis auf die Grenzfläche des p-leitenden Halbleitergebietes aufgebracht werden,
   - so dass bereits vor einem Temperprozeß das vorgegebene Mischungsverhältnis beider Materialkomponenten an der Grenzfläche zwischen dem p-leitenden Halbleitergebiet und dem p-Kontaktgebiet eingestellt wird.

Die Erfindung beruht dabei auf der Erkenntnis, daß entgegen der üblichen Vorgehensweise der Fachwelt eine stabile und reproduzierbare ohmsche Kontaktierung von p-leitendem Siliciumcarbid nicht nur über das sukzessive Aufbringen zweier oder mehrerer Schichten jeweils unterschiedlichen Materials, sondern speziell als eine einzige Schicht mit annähernd gleicher, d.h. homogener Materialzusammensetzung erfolgen kann. Das betreffende p-Kontaktgebiet setzt sich aus einem Material zusammen, das die beim Stand der Technik für die einzelnen Schichten verwendeten Materialien Nickel und Aluminium als erste bzw. zweite Materialkomponente enthält. Das Material kann dabei in Form eines Gemisches, eines Gemenges, einer Legierung oder einer Verbindung dieser beiden Materialkomponenten vorliegen.

Vor Beginn des Temperprozesses liegt an der Grenzfläche zum SiC bereits ein quarternäres Materialsystem aus den Einzelkomponenten Silicium, Kohlenstoff, Nickel und Aluminium vor. Dies wirkt sich besonders günstig auf die ohmsche Kontaktbildung während des Temperprozesses aus. Ein gewünschtes Mischungsverhältnis zwischen dem Aluminium und dem Nickel insbesondere an der Grenzfläche zum p-leitenden SiC läßt sich problemlos bereits beim gleichzeitigen Aufbringen der beiden Materialkomponenten vor dem Temperprozeß einstellen. Da keine weitere Deck- oder Schutzschicht aus einem anderen Material auf dem Kontaktgebiet vorgesehen ist, liegen auch nach dem Tempern in dem Grenzbereich praktisch ausschließlich, d.h. abgesehen von unvermeidbaren Verunreinigungen und den Dotierstoffatomen des p-leitenden Halbleitergebiets, die vier genannten Elemente des quarternären Materialsystems vor. Eine mögliche Beeinträchtigung des Kontaktwiderstands wie beim Stand der Technik tritt also nicht auf, da der Grenzbereich praktisch frei von unerwünschten Fremdatomen ist.

Gegenüber dem gleichzeitigen Aufbringen beider Materialkomponenten wäre ein sukzessives Aufbringen einer ersten Schicht aus Aluminium und einer zweiten Schicht aus Nickel ungünstiger, da sich beide Materialkomponenten während des anschließenden Temperprozesses zunächst erst hinreichend durchmischen müßten, um an der Grenzfläche gleichermaßen zur Verfügung zu stehen. Zu Beginn des Temperprozesses läge somit bei einem schichtweisen Aufbringen der beiden Maerialkomponenten noch kein für die ohmsche Kontaktbildung besonders günstiges quarternäres System an der Grenzfläche zwischen Kontaktschicht und Halbleitergebiet vor. Ein gleichzeitiges Aufbringen der beiden Materialkomponenten vereinfacht demgegenüber außerdem auch den Fertigungsprozeß, da ein separater Prozeßschritt für eine zweite Schicht entfällt.

Ein Material aus Nickel und Aluminium bietet außerdem gegenüber der im Stand der Technik verwendeten Aluminium-Titan-Legierung den Vorteil, daß Nickel bei einer Erwärmung über 300-400°C, beispielsweise während der Formierung, im Gegensatz zu dem carbidbildenden Titan ein Silicid bildet. Dadurch wird in dem SiC-Gefüge des p-leitenden Halbleitergebietes eine Silicium-Position frei, an die Aluminium als Akzeptor eingebunden werden kann. Im Gegensatz dazu läßt sich Aluminium jedoch nicht an eine aufgrund der Carbidisierung von Titan freiwerdende Kohlenstoff-Postion als Akzeptor in das Kristallgefüge einbinden. Deshalb und auch wegen der verglichen mit Titan höheren Temperaturstabilität von Nickel resultiert bei einem für das p-Kontaktgebiet verwendeten Material, das sich aus Nickel und aus Aluminium zusammensetzt, ein stabiler Kontakt mit einem niedrigen Kontaktwiderstand.

Nach dem Temperprozeß stellt sich innerhalb des p-Kontaktgebiets eine leichte Abweichung von der Materialhomogenität ein. Diese geringfügige Inhomogenität rührt von Austauschvorgängen zwischen den Materialien in dem Grenzbereich des p-Kontaktgebiets und des p-leitenden Halbleitergebiets.

So wird beispielsweise in dem Grenzbereich das Aluminium des aufgebrachten Materials in gewissem Umfang in das p-leitende Halbleitergebiet wandern, wo es als Akzeptor an den entsprechenden Gitterstellen eingebunden wird. Desgleichen ergibt sich eine Verschiebung der Materialzusammensetzung im Grenzbereich, da das Material des p-Kontaktgebiets mit dem Nickel, wie bereits erwähnt, eine silicidbildende Materialkomponente enthält. Silicium aus dem p-leitenden Halbleitergebiet durchmischt sich folglich mit dem Nickel des p-Kontaktgebiets und bildet ein entsprechendes Silicid.

Der Bereich, in dem die beschriebenen Durchmischungsvorgänge stattfinden, erstreckt sich jedoch nicht bis in die Tiefe des p-Kontaktgebiets, so daß sich die erwähnten Unterschiede in der Materialzusammensetzung in erster Linie nur in dem Grenzbereich ergeben. Der Ausdruck "annähernd gleiche Materialzusammensetzung" ist in diesem Sinne zu verstehen.

Außerdem werden Unterschiede in der Materialzusammensetzung, die auf übliche Verunreinigungen in Ausgangssubstanzen zurückzuführen sind, hier ebenfalls als nicht maßgeblich betrachtet. Derartige Verunreinigungen können auf einem Volumen-Anteil von höchstens 10⁻³, häufig sogar nur von höchstens 10⁻⁶, vorhanden sein.

Besondere Ausgestaltungen und Weiterbildungen der Halbleiteranordnung und des Verfahrens nach der Erfindung ergeben sich aus den jeweils abhängigen Unteransprüchen.

In einer vorteilhaften Ausführungsform liegt das Aluminium mit einem Volumen-Anteil von 0,1 bis 50 % in dem Material vor. Besonders bevorzugt ist dabei ein Anteil von 20 bis 50 %, da sich der erreichbare Kontaktwiderstand in diesem Bereich mit zunehmendem Aluminium-Anteil kontinuierlich verbessert. Es hat sich gezeigt, daß die Verflüchtigung des Aluminiums deutlich reduziert und sogar unterdrückt werden kann, wenn der Volumen-Anteil von Aluminium kleiner als 50 % gewählt wird. Der Nickel-Anteil im Material, der dann entsprechend größer als 50 % ist, verhindert dabei gerade bei steigenden Temperaturen die Bildung von flüssigen Aluminium-Inseln und das resultierende unerwünschte Abdampfen von Aluminium. Durch die Wahl des Nickel- und des Aluminium-Anteils innerhalb der angegebenen Grenzen wird die Stabilität somit zusätzlich erhöht. Insbesondere bei dem Temperprozeß, der zur Formierung des ohmschen Kontakts vorteilhafterweise durchgeführt wird, ist dies von Nutzen, aber auch falls die Halbleiteranordnung für eine Anwendung im Hochtemperaturbereich vorgesehen sein sollte. Aufgrund der diesbezüglich hervorragenden Eigenschaften von SiC ist dies ein bevorzugter Anwendungsfall für ein SiC-Bauelement.

Für die Ausbildung eines guten ohmschen Kontakts ist es vorteilhaft, wenn das p-leitende Halbleitergebiet eine ausreichend hohe Dotierstoffkonzentration zumindest an der Grenzfläche des Halbleitergebietes zum p-Kontaktgebiet aufweist. Bevorzugt liegt dabei die Dotierstoffkonzentration zwischen 10¹⁷ cm⁻³ und 10²⁰ cm⁻³. Ein besonders guter Kontakt ergibt sich, wenn die Dotierstoffkonzentration mindestens 10¹⁹ cm⁻³ beträgt.

Vorteilhafte Ausführungsformen des Verfahrens, die sich aus den entsprechenden Unteransprüchen ergeben, weisen im wesentlichen die gleichen Vorteile auf wie die obengenannten jeweils korrespondierenden Weiterbildungen der Halbleiteranordnung selbst.

Andere Ausbildungen des Verfahrens beziehen sich auf das Aufbringen des Materials auf das p-leitende Halbleitergebiet.

In einer Ausbildung des Verfahrens wird das Material, das auf die beiden Halbleitergebiete aufgebracht wird, mindestens zwei getrennten Quellen entnommen. Die Quellen enthalten dabei jeweils mindestens eine Materialkomponente, insbesondere die erste oder die zweite. Die Entnahme erfolgt durch gleichzeitiges Verdampfen oder Zerstäuben (Sputtern). Das p-Kontaktgebiet wird anschließend durch Abscheiden der Materialkomponenten auf dem p-leitenden Halbleitergebiet gebildet. Das Material für das p-Kontaktgebiet entsteht dabei entweder noch in der Gasphase aus den einzelnen Materialkomponenten oder im Laufe des Abscheidevorgangs. Durch die Prozeßparameter kann gewährleistet werden, daß ein bestimmtes beabsichtigtes Mischungsverhältnis eingehalten wird.

Eine alternative Ausbildung sieht dagegen vor, daß aus der ersten und zweiten Materialkomponente zunächst ein Quellmaterial hergestellt wird, das dann in einem zweiten Verfahrensschritt zerstäubt wird. Die herausgelösten Partikel des Materials bilden wie in der vorher beschriebenen Ausbildung das p-Kontaktgebiet auf dem p-leitenden Siliciumcarbid.

In einer vorteilhaften Ausführungsvariante wird die Halbleiteranordnung, nachdem das p-Kontaktgebiet aufgebracht worden ist, einem kurzzeitigen Temperprozeß unterzogen. Bevorzugt wird die Halbleiteranordnung dabei auf eine Maximaltemperatur von mindestens 500°C, insbesondere von etwa 1000°C, erhitzt und dann für bis zu 2 Stunden, insbesondere für 2 Minuten, auf etwa dieser Maximaltemperatur gehalten. Der Temperprozeß kann aber auch nur aus einer Aufheizphase und einer unmittelbar folgenden Abkühlphase bestehen, ohne daß dazwischen eine Verweildauer bei einer Maximaltemperatur vorgesehen wird. Dieser Prozeß dient der Formierung des p-Kontaktgebiets. Es zeigt sich, daß nach diesem Temperprozeß auf dem p-leitendem SiC ein temperaturstabiler Kontakt mit guter ohmscher Charakteristik und niedrigem Kontaktwiderstand resultiert.

Das zu kontaktierende p-leitende Halbleitergebiet kann aus SiC verschiedenen Polytyps bestehen. Es gibt Ausführungsformen, bei denen SiC in Form von 6H-, 4H-, 15R- oder 3C-SiC für das p-leitende Halbleitergebiet verwendet wird. Andere Polytypen sind jedoch ebenfalls möglich.

Außerhalb des p-leitenden Halbleitergebiets kann die Halbleiteranordnung auch zumindest bereichsweise aus einem anderen Material als SiC bestehen. Deshalb ist in einer Ausführungsform zumindest ein weiteres Halbleitergebiet, beispielsweise ein Substrat, aus einem von SiC verschiedenen Material, beispielsweise aus Silicium (Si), Galliumarsenid (GaAs) oder Galliumnitrid (GaN), vorgesehen. Dieses Substrat ist dann zumindest mit dem p-leitenden Halbleitergebiet aus SiC zu einer hybriden Halbleiteranordnung integriert.

Ausführungsbeispiele gemäß der Erfindung werden nunmehr anhand der Zeichnung näher erläutert. Zur Verdeutlichung ist die Zeichnung nicht maßstäblich ausgeführt und gewisse Merkmale sind schematisiert dargestellt. Im einzelnen zeigen:
- Figur 1: eine Halbleiteranordnung in Form einer pn-Diode mit einem p-leitenden Halbleitergebiet aus SiC und einem angrenzenden p-Kontaktgebiet und
- Figur 2: eine weitere Halbleiteranordnung mit einem p-leitenden Halbleitergebiet aus SiC und einem p-Kontaktgebiet.

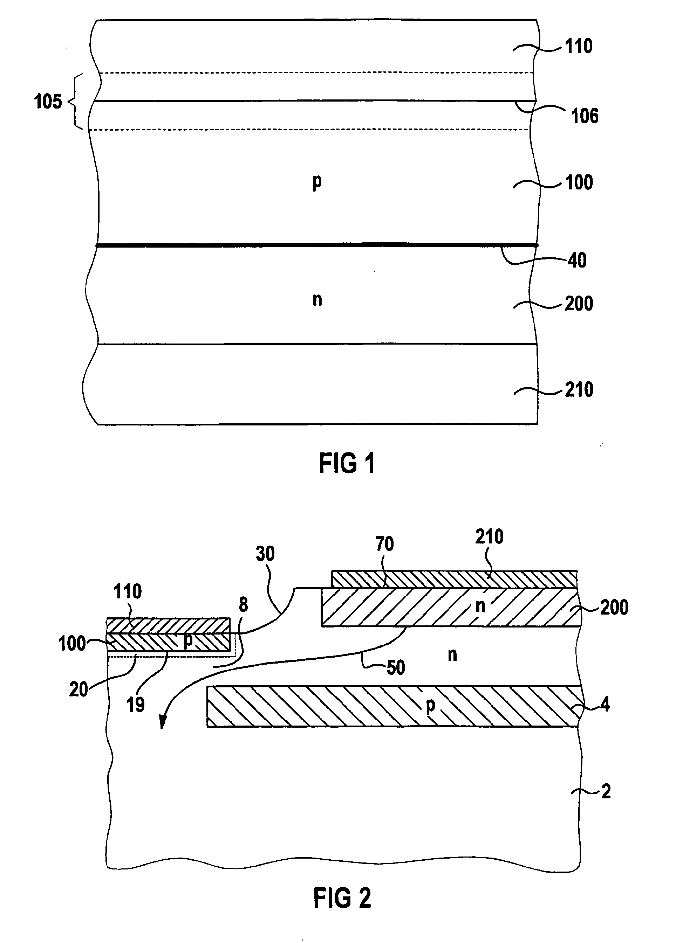

Einander entsprechende Teile sind in den Figuren 1 und 2 mit denselben Bezugszeichen versehen.

Die in der Figur 1 gezeigte Halbleiteranordnung ist eine pn-Diode, bei der ein ohmsches p-Kontaktgebiet 110 auf einer Grenzfläche 106 eines p-leitenden Halbleitergebiets 100 aus 6H-SiC angeordnet ist. Ein Übergangsbereich 105 erstreckt sich sowohl in das p-Kontaktgebiet 110 als auch in das p-leitende Halbleitergebiet 100. Ein n-leitendes Halbleitergebiet 200 ebenfalls aus 6H-SiC bildet mit dem p-leitenden Halbleitergebiet 100 einen pn-Übergang 40. Das n-leitende Halbleitergebiet 200 ist auf einer dem pn-Übergang 40 abgewandten Oberfläche ebenfalls mit einem ohmschen Kontaktgebiet, einem n-Kontaktgebiet 210, kontaktiert.

Der in der Figur 1 gezeigte pn-Übergang 40 kann ein eigenes Bauelement in Form einer pn-Diode darstellen, er kann aber auch Bestandteil einer komplexeren Schaltungsanordnung sein. In beiden Fällen ist jedoch eine ohmsche Kontaktierung zumindest eines p-leitenden Halbleitergebiets aus SiC notwendig.

Das p-leitende Halbleitergebiet 100 ist mit einem hohen Anteil an Akzeptoren, im vorliegenden Fall Aluminium, dotiert. Als Resultat ergibt sich p-leitendes Verhalten. Das n-leitende Halbleitergebiet 200 weist dagegen eine hohe Dotierstoffkonzentration an Stickstoff auf. Stickstoff stellt in Siliciumcarbid einen Donator dar, so daß n-leitendes Verhalten resultiert. Die Dotierstoffkonzentrationen im p- und n-leitenden Halbleitergebiet 100 und 200 liegen bei jeweils 10¹⁹ cm⁻³. Dadurch wird die Ausbildung guter ohmscher Kontakte auf den beiden Halbleitergebieten 100 und 200 begünstigt. In einem in Figur 1 nicht dargestellten Grenzbereich zum pn-Übergang 40 ist das n-leitende Halbleitergebiet 200 schwächer dotiert, z.B. mit einer Konzentration von 10¹⁵ cm⁻³.

Das p-Kontaktgebiet 110 besteht aus einem Material, das sich im vorliegenden Fall aus einer ersten und einer zweiten Materialkomponente zusammensetzt. Die erste Materialkomponente ist Nickel, die zweite Aluminium. Der Volumen-Anteil des Aluminiums liegt bei etwa 30 %, der des Nickels bei etwa 70 %.

Aluminium wird auf p-leitendem SiC zur ohmschen Kontaktierung verwendet, hat aber einen relativ niedrigen Schmelzpunkt. Um ein etwaiges Abdampfen zu vermeiden, wird dem Material für das p-Kontaktgebiet 110 Nickel beigemischt. Der Nickel-Anteil ist dabei so groß, daß er gegenüber dem Aluminium-Anteil erheblich überwiegt. Dadurch wird zum einen der Kontaktwiderstand verbessert, und zum anderen gewinnt man durch diese Maßnahme eine erheblich verbesserte Temperaturstabilität.

Die Durchmischung des Aluminiums und Nickels ist in dem kompletten p-Kontaktgebiet 110 nahezu homogen. Lediglich in dem Grenzbereich 105 kann es aufgrund von Material-Austauschvorgängen insbesondere nach einem anschließend durchgeführten Temperprozeß zu leichten Abweichungen kommen.

Das n-Kontaktgebiet 210 besteht demgegenüber aus reinem Nickel, das sowohl einen guten ohmschen Kontakt auf n-leitendem SiC bildet, als auch eine gute Temperaturstabilität aufweist.

Das Material für das p-Kontaktgebiet 110 wird durch Verdampfen aus nicht dargestellten, getrennten Nickel- bzw. Aluminium-Quellen erzeugt. Anschließend erfolgt die Bildung des p-Kontaktgebiets 110 durch Abscheiden des gasförmigen Materials auf dem p-leitenden Halbleitergebiet 100. An der Grenzfläche 106 liegen somit bereits nach diesem Materialauftrag Nickel und Aluminium in dem vorbestimmten Mischungsverhältnis vor.

In einem separaten Prozeßschritt wird dann Nickel ebenfalls durch Verdampfen aus einer nicht dargestellten Quelle auf dem n-leitenden Halbleitergebiet 200 abgeschieden.

Zur Formierung und zur Bildung ohmscher, temperaturstabiler Kontakte wird die Halbleiteranordnung anschließend einem ca. zweiminütigem Temperprozeß bei etwa 1000°C unterzogen. Danach ergibt sich zwischen dem p-leitenden Halbleitergebiet 100 und dem p-Kontaktgebiet 110 ein Kontaktwiderstand von unter 10⁻³ Ωcm² und zwischen dem n-leitenden Halbleitergebiet 200 und dem n-Kontaktgebiet 210 ein Kontaktwiderstand von unter 10⁻⁵ Ωcm².

In Figur 2 ist eine Halbleiteranordnung dargestellt, bei der das p- und das n-Kontaktgebiet 110 und 210 auf einer gemeinsamen Schichtoberfläche 70 der Halbleiteranordnung angeordnet sind.

Die Funktion der Halbleiteranordnung von Figur 2 besteht darin, einen Stromfluß 50, der von dem n-leitenden Halbleitergebiet 200 bzw. vom n-Kontaktgebiet 210 ausgeht und der durch eine n-SiC-Schicht 2 verläuft, innerhalb eines Kanalbereichs 8 dieser n-SiC-Schicht 2 zu steuern. Dazu kann der Kanalbereich 8 durch das p-leitende Halbleitergebiet 100 und eine in der n-SiC-Schicht 2 vergrabene p-Insel 4 in seinen Dimensionen und damit seinem Widerstand verändert werden. Dies geschieht über das Anlegen einer Spannung an das p-Kontaktgebiet 110, wodurch sich eine Verarmungszone 20 an einem pn-Übergang 19 zwischen der n-SiC-Schicht 2 und dem p-leitenden Halbleitergebiet 100 u.a. in den Kanalbereich 8 hinein ausbreitet. Die Dimension des Kanalbereichs 8 wird zusätzlich voreingestellt, indem eine Vertiefung 30 vorgesehen ist, in der sich das p-leitende Halbleitergebiet 100 befindet.

Sowohl das p-leitende Halbleitergebiet 100 als auch das n-leitende Halbleitergebiet 200 benötigen für die beschriebene Funktionsweise eine ohmsche Kontaktierung in Form des p- und n-Kontaktgebiets 110 bzw. 210.

Das p-leitende Halbleitergebiet 100 weist eine Dotierung mit dem Akzeptor Bor auf, das n-leitende Halbleitergebiet 200 eine Dotierung mit dem Donator Phosphor. Die Dotierstoffkonzentration beträgt jeweils 10¹⁹ cm⁻³. Als Material für das p-Kontaktgebiet 110 dient im Ausführungsbeispiel von Figur 2 ein Materialgemisch, das sich wiederum aus der ersten Materialkomponente Nickel und der zweiten Materialkomponente Aluminium zusammensetzt. Der Volumen-Anteil von Aluminium beträgt hierbei etwa 25 %, der von Nickel etwa 75 %. Als Material für das n-Kontaktgebiet 210 dient wiederum Nickel. Das Aufbringen des Materials sowie der anschließende Temperprozeß erfolgen wie im Zusammenhang mit Figur 1 bereits beschrieben.

In einer nicht dargestellten Ausführungsform sind mehrere der in den Figuren 1 und 2 gezeigten Halbleiteranordnungen Bestandteil einer komplexen Halbleiteranordnung, die folglich eine Vielzahl von p-leitenden Halbleitergebieten 100 nebst der Kontaktierung über die zugehörigen p-Kontaktgebiete 110 beinhaltet.

## Patentansprüche

1. Halbleiteranordnung mit ohmscher Kontaktierung umfassend:
a) mindestens ein p-leitendes Halbleitergebiet (100) aus Siliciumcarbid und
b) mindestens ein an das p-leitende Halbleitergebiet (100) angrenzendes p-Kontaktgebiet (110), wobei
c) das p-Kontaktgebiet (110) aus einem Material mit Nickel als erster Materialkomponente und Aluminium als zweiter Materialkomponente besteht, **gekennzeichnet durch** die weiteren Merkmale:
d) im p-Kontaktgebiet (110) liegt eine annähernd homogene Materialzusammensetzung der beiden Materialkomponenten Nickel und Aluminium vor,
e) in einem Grenzbereich (105) zwischen dem p-leitenden Halbleitergebiet (100) und dem p-Kontaktgebiet (110) ist ein quaternäres Materialsystem mit Silicium (Si) und Kohlenstoff (C) sowie Nickel (Ni) und Aluminium (Al) vorhanden.

2. Halbleiteranordnung nach Anspruch 1, **dadurch gekennzeichnet, dass** das Aluminium in dem Material mit einem Volumen-Anteil von 0,1 % bis 50 %, insbesondere von 20 % bis 50 %, enthalten ist.

3. Halbleiteranordnung nach Anspruch 1 oder 2, **dadurch gekennzeichnet, dass** das p-leitende Halbleitergebiet (100) eine Dotierstoffkonzentration zwischen 10¹⁷ cm⁻³ und 10²⁰ cm⁻³ aufweist.

4. Verfahren zur Kontaktierung einer Halbleiteranordnung, bei dem
a) mindestens ein weitgehend homogenes p-Kontaktgebiet (110) auf mindestens einem p-leitenden Halbleitergebiet (100) aus Siliciumcarbid ausgebildet wird, indem
b) für das p-Kontaktgebiet (110) ein Material mit Nickel als einer ersten Materialkomponente und Aluminium als einer zweiten Materialkomponente aufgebracht wird,
**gekennzeichnet durch** folgende weitere Maßnahmen:
c) beide Materialkomponenten werden gleichzeitig in einem vorgegebenen Mischungsverhältnis auf die Grenzfläche (106) des p-leitenden Halbleitergebietes (100) aufgebracht, so dass
d) bereits vor einem Temperprozess das vorgegebene Mischungsverhältnis beider Materialkomponenten an der Grenzfläche (106) zwischen dem p-leitenden Halbleitergebiet (100) und dem p-Kontaktgebiet (110) eingestellt wird.

5. Verfahren nach Anspruch 4, **dadurch gekennzeichnet, dass** für das Aluminium ein Volumen-Anteil von 0,1 % bis 50 %, insbesondere von 20 % bis 50 %, in dem Material vorgesehen wird.

6. Verfahren nach Anspruch 4 oder 5, **dadurch gekennzeichnet, dass** in dem p-leitenden Halbleitergebiet (100) eine Dotierstoffkonzentration zwischen 10¹⁷ cm⁻³ und 10²⁰ cm⁻³ vorgesehen wird.

7. Verfahren nach einem der Ansprüche 4 bis 6, **dadurch gekennzeichnet, dass** das Material durch gleichzeitiges Verdampfen oder Zerstäuben aus zwei getrennten Quellen der ersten und zweiten Materialkomponente aufgebracht wird.

8. Verfahren nach einem der Ansprüche 4 bis 6, **dadurch gekennzeichnet, dass** ein Quellmaterial vorab aus der ersten und zweiten Materialkomponente hergestellt wird und das Material dann durch Zerstäuben des Quellmaterials aufgebracht wird.

9. Verfahren nach einem der Ansprüche 4 bis 7, **dadurch gekennzeichnet, dass** die das p-leitende Halbleitergebiet (100) sowie das aufgebrachte p-Kontaktgebiet (110) umfassende Halbleiteranordnung einem Temperprozess mit einer Erhitzung auf eine Maximaltemperatur von mindestens 500°C, vorzugsweise von etwa 1000°C, unterzogen wird.

10. Verfahren nach Anspruch 9, **dadurch gekennzeichnet, daß** die Maximaltemperatur für eine Dauer von höchstens 2 Stunden, vorzugsweise von höchstens 2 Minuten, konstant gehalten wird.

## Claims

1. Semiconductor arrangement with ohmic contact-connection comprising:
a) at least one p-conducting semiconductor region (100) made of silicon carbide and
b) at least one p-type contact region (110) adjoining the p-conducting semiconductor region (100), in which case
c) the p-type contact region (110) is composed of a material having nickel as first material component and aluminium as second material component,
**characterized by** the further features:
d) an approximately homogeneous material composition of the two material components nickel and aluminium is present in the p-type contact region (110),
e) a quaternary material system comprising silicon (Si) and carbon (C) and nickel (Ni) and aluminium (A1) is present in a boundary region (105) between the p-conducting semiconductor region (100) and the p-type contact region (110) .

2. Semiconductor arrangement according to Claim 1, **characterized in that** the aluminium is contained in the material with a proportion by volume of from 0.1% to 50%, in particular from 20% to 50%.

3. Semiconductor arrangement according to Claim 1 or 2, **characterized in that** the p-conducting semiconductor region (100) has a dopant concentration of between 10¹⁷ cm⁻³ and 10²⁰ cm⁻³.

4. Method for contact-connecting a semiconductor arrangement, in which
a) at least one largely homogeneous p-type contact region (110) is formed on at least one p-conducting semiconductor region (100) made of silicon carbide by
b) a material having nickel as a first material component and aluminium as a second material component being applied, for the p-type contact region (110),
**characterized by** the following further measures:
c) both material components are applied simultaneously to the interface (106) of the p-conducting semiconductor region (100) in a predetermined mixture ratio, so that
d) the predetermined mixture ratio of both material components is already established at the interface (106) between the p-conducting semiconductor region (100) and the p-type contact region (110) before a heat-treatment process.

5. Method according to Claim 4, **characterized in that**, for the aluminium, a proportion by volume of from 0.1% to 50%, in particular from 20% to 50%, is provided in the material.

6. Method according to Claim 4 or 5, **characterized in that** a dopant concentration of between 10¹⁷ cm⁻³ and 10²⁰ cm⁻³ is provided in the p-conducting semiconductor region (100).

7. Method according to one of Claims 4 to 6, **characterized in that** the material is applied by simultaneous vaporization or sputtering from two separate sources of the first and second material components.

8. Method according to one of Claims 4 to 6, **characterized in that** a source material is prepared in advance from the first and second material components and the material is then applied by sputtering the source material.

9. Method according to one of Claims 4 to 7, **characterized in that** the semiconductor arrangement comprising the p-conducting semiconductor region (100) and the applied p-type contact region (110) is subjected to a heat-treatment process with heating to a maximum temperature of at least 500°C, preferably of about 1 000°C.

10. Method according to Claim 9, **characterized in that** the maximum temperature is kept constant for a duration of at most 2 hours, preferably of at most 2 minutes.

## Revendications

1. Ensemble semi-conducteur avec établissement de contact ohmique, comprenant:
a) au moins une zone semi-conductrice de type p (100) en carbure de silicium et
b) au moins une zone de contact de type p (110) adjacente à la zone semi-conductrice de type p (100), dans lequel
c) la zone de contact de type p (110) est composée d'un matériau avec du nickel en tant que premier composant du matériau et de l'aluminium en tant que deuxième composant du matériau,
**caractérisé par** les caractéristiques supplémentaires:
d) dans la zone de contact de type p (110) se trouve une composition du matériau approximativement homogène des deux composants du matériau nickel et aluminium;
e) dans une zone limite (105) située entre la zone semi-conductrice de type p (100) et la zone de contact de type p (110) est présent un système de matériau quaternaire avec du silicium (Si) et du carbone (C) ainsi que du nickel (Ni) et de l'aluminium (A1).

2. Ensemble semi-conducteur selon la revendication 1, **caractérisé en ce que** l'aluminium est contenu dans le matériau à concurrence d'une fraction volumique de 0,1 % à 50 %, et plus particulièrement de 20 % à 50 %.

3. Ensemble semi-conducteur selon la revendication 1 ou 2, **caractérisé en ce que** la zone semi-conductrice de type p (100) présente une concentration de dopant comprise entre 10¹⁷ cm⁻³ et 10²⁰ cm⁻³.

4. Procédé pour établir un contact avec un ensemble semi-conducteur, dans lequel
a) on réalise au moins une zone de contact de type p (110) largement homogène sur au moins une zone semi-conductrice de type p (100) en carbure de silicium
b) par application d'un matériau avec du nickel en tant que premier composant du matériau et de l'aluminium en tant que deuxième composant du matériau pour la zone de contact de type p (110),
**caractérisé par** les autres mesures suivantes:
c) les deux composants du matériau sont appliqués simultanément dans un rapport de mélange prédéfini sur la surface limite (106) de la zone semi-conductrice de type p (100) de sorte que
d) déjà avant un processus de recuit thermique le rapport de mélange prédéfini des deux composants du matériau est ajusté à la surface limite (106) entre la zone semi-conductrice de type p (100) et la zone de contact de type p (110) .

5. Procédé selon la revendication 4, **caractérisé en ce qu'**est prévue, pour l'aluminium, dans le matériau, une fraction volumique de 0,1 % à 50 %, et plus particulièrement de 20 % à 50 %.

6. Procédé selon la revendication 4 ou 5, **caractérisé en ce qu'**est prévue, dans la zone semi-conductrice de type p (100), une concentration de dopant comprise entre 10¹⁷ cm⁻³ et 10²⁰ cm⁻³.

7. Procédé selon l'une des revendications 4 à 6, **caractérisé en ce que** le matériau est appliqué par vaporisation ou pulvérisation simultanée à partir de deux sources séparées des premier et deuxième composants du matériau.

8. Procédé selon l'une des revendications 4 à 6, **caractérisé en ce qu'**un matériau source est fabriqué préalablement à partir des premier et deuxième composants du matériau et le matériau est alors appliqué par pulvérisation du matériau source.

9. Procédé selon l'une des revendications 4 à 7, **caractérisé en ce que** l'ensemble semi-conducteur comprenant la zone semi-conductrice de type p (100) et la zone de contact de type p (110) appliquée est soumis à un processus de recuit thermique avec chauffage à une température maximale d'au moins 500 °C, et de préférence d'environ 1000 °C.

10. Procédé selon la revendication 9, **caractérisé en ce que** la température maximale est maintenue constante pour une durée de 2 heures au maximum, et de préférence de 2 minutes au maximum.
